# FASCICULE DE BREVET EUROPEEN

(11) **EP 1 623 369 B1**
(45) Date de publication et mention de la délivrance du brevet: **07.02.2007**
(21) Numéro de dépôt: 04732370.4
(22) Date de dépôt: 12.05.2004
(51) Int. Cl.: G06K 19/077, B23K 1/00

(54) **PROCEDE D' ASSEMBLAGE D UN COMPOSANT ELECTRONIQUE SUR UN SUBSTRAT**
VERFAHREN ZUM ZUSAMMENBAUEN EINES ELEKTRONISCHEN KOMPONENT AUF EINEM SUBSTRAT
METHOD FOR MOUNTING AN ELECTRONIC COMPONENT ON A SUBSTRATE

(30) Priorité: 13.05.2003 CH 20030832
(43) Date de publication de la demande: 08.02.2006
(73) Titulaire: Nagraid SA, 2301 La Chaux-de-Fonds (CH)
(72) Inventeur: DROZ, François, CH-2300 La Chaux-de-Fonds (CH)
(74) Mandataire: Wenger, Joel-Théophile
(86) Numéro de dépôt international: PCT/IB2004/050645
(87) Numéro de publication internationale: WO 2004/102469

(56) Documents cités:
- EP-A- 0 756 442
- EP-A- 0 786 357
- EP-A- 0 952 545
- US-A1- 2002 110 955

## Description

La présente invention concerne un procédé d'assemblage d'un composant électronique sur un support isolant appelé substrat comportant une pluralité de pistes conductrices. Ce procédé peut être appliqué lors de la fabrication de transpondeurs sous forme de carte ou d'étiquette électronique en général de faible épaisseur.

On entend par étiquette électronique, un ensemble comprenant au moins un support isolant, une antenne et un composant électronique, en général une puce. La carte ou l'étiquette électronique fabriquée en utilisant le procédé selon l'invention se trouve dans de nombreuses applications comme moyen d'identification, de contrôle ou de paiement.

Le sujet de la présente invention se concentre particulièrement sur le montage d'au moins un composant électronique sur le substrat d'une carte ou d'une étiquette de faible épaisseur. Un composant électronique est un élément tel que: une puce, une capacité, une résistance, une diode, un fusible, une batterie, un affichage, ou encore un ensemble comprenant une puce surmoulée munie de plages de contacts.

Il est connu de l'homme du métier des cartes ou des étiquettes où des composants sont montés sur un substrat, sur lequel sont gravées des pistes et des plages de connexion en matériau conducteur (cuivre en général). Les composants sont en général collés, puis leurs contacts sont soudés sur les pistes ou sur les plages de connexion conductrices du substrat. Le contact électrique entre les plages de connexion du composant et celles du substrat est réalisé par des moyens tels que: collage avec une colle conductrice, soudage à l'aide d'ultrasons, soudage à l'aide d'un alliage à base d'étain appliqué à chaud.

Il est aussi connu des cartes munies de composants dont les contacts sont pourvus de griffes ou de pointes (bumps) qui sont enfoncées par pressage dans les plages de connexion gravées du substrat. Le document W00055808 décrit la réalisation d'une connexion entre une puce et des plages de contacts d'une antenne par laminage à chaud. Les contacts de la puce comportent des bossages qui s'incrustent dans la matière conductrice des plages de connexion de l'antenne occasionnant une déformation de ces plages.

Les liaisons des composants aux conducteurs du substrat peuvent aussi être effectuées au moyen de fils conducteurs soudés d'une part sur un conducteur du substrat et d'autre part sur une plage conductrice du composant.

Afin de protéger les composants et les circuits ainsi câblés, une résine époxy peut être coulée sur tout ou partie de la surface du substrat afin d'enrober l'ensemble des composants du circuit. Selon une autre réalisation, une feuille isolante est laminée sur tout ou partie du substrat recouvrant le ou les composants et les pistes conductrices avoisinantes.

Le document EP0786357, qui reprend le préambule de la revendication 1, décrit une carte sans contact comprenant une puce montée sur un substrat et connectée à une bobine d'antenne disposée sur le pourtour du substrat. La puce est placée dans une zone du substrat située à l'extérieur de la boucle formée par la bobine d'antenne dans le voisinage d'un des bords de la carte. Cette position décentrée de la puce la protège contre des contraintes provoquées par une courbure de la carte. La connexion de la bobine d'antenne à la puce est effectuée par pressage à chaud des bossages des contacts de la puce sur les pistes de terminaison de la bobine. Selon une variante cette connexion est réalisée par soudage de fils ("wire-bonding") entre les contacts de la puce et les pistes issues de la bobine.

Le document US2002/0110955 décrit une méthode de fabrication d'un module électronique comprenant un substrat et au moins une puce. Cette dernière est soit collée sur une des faces du substrat, soit pressée à chaud dans l'épaisseur du substrat de manière à affleurer sa surface. Le substrat comporte en outre des plages conductrices auxquelles la puce est connectée au moyen de pistes conductrices tracées par sérigraphie, selon une variante préférée. Les contacts de la puce comportent des bossages sur lesquelles les pistes, ainsi tracées, aboutissent en les recouvrant. Une étape finale consiste à appliquer un film mince ou une laque de protection sur la puce et sur les pistes conductrices à proximité de la puce.

Les transpondeurs dont les composants sont assemblés selon les procédés connus décrits ci-dessus présentent un inconvénient au niveau de la qualité et de la fiabilité de la connexion du composant au conducteur. En effet, cette connexion peut être interrompue totalement ou de manière intermittente en fonction les contraintes mécaniques subies par le transpondeur lors de son utilisation. Plus particulièrement, les transpondeurs de faible épaisseur comme des cartes ou des étiquettes électroniques sont aisément déformables par flexion ou par torsion. Ces contraintes peuvent apparaître lors de l'utilisation courante du transpondeur comme par exemple sur une étiquette appliquée sur une surface d'un objet présentant des protubérances.

Malgré la protection des composants par surmoulage ou par laminage d'une feuille isolante, les connexions des composants sont soumises à des forces internes de traction et de compression qui provoquent leur rupture lorsque le transpondeur est déformé. Ce phénomène est encore accentué lors de déformations répétitives qui entraînent la fatigue de la liaison qui finalement se rompt après un certain nombre de flexions ou de torsions subies par le transpondeur.

Le but de la présente invention est de pallier les inconvénients décrits ci-dessus à savoir d'accroître la fiabilité et la qualité de la liaison électrique entre le ou les composants électroniques et les pistes conductrices du substrat tout en réduisant les coûts de fabrication du transpondeur.

La présente invention a également pour but de proposer un procédé de fabrication d'un tel transpondeur sous forme de carte ou d'étiquette capable de résister à des flexions ou des torsions sans interruption des connexions des composants.

Ces buts sont atteints par un procédé d'assemblage d'au moins un composant électronique comportant des plages conductrices sensiblement planes connectées à des pistes conductrices disposées sur la surface d'un support isolant généralement plan appelé substrat par les étapes suivantes:
- poser le substrat sur une surface de travail, la face comportant les pistes conductrices étant dirigée vers le haut,
- placer le composant électronique dans un logement du substrat situé dans une zone comportant les pistes conductrices, les plages conductrices du composant entrant en contact avec des pistes correspondantes du substrat,
- appliquer une couche de matière isolante s'étendant à la fois sur le composant et au moins sur une zone du substrat entourant ledit composant, le contact entre les plages conductrices du composant électronique et les pistes conductrices du substrat réalise une connexion électrique assurée par la pression d'application de la couche isolante sur le composant électronique.

Le composant électronique aussi appelé module électronique est en général formé d'une puce dont les contacts situés sur une de ses faces sont rapportés sur une feuille conductrice, appelée "leadframe" constituant des plages de contact qui prolongent les contacts de petites dimensions de la puce. Dans un exemple de réalisation, la face opposée de la puce est surmoulée par une matière isolante en général de la résine époxy. Le "leadframe" permet de faciliter la connexion du module électronique sur des pistes conductrices d'un circuit imprimé. La plupart des composants à semi-conducteur montés sur la surface de circuits imprimés comportent de tels "leadframe".

Les pistes conductrices du substrat sont définies au sens large. Elles peuvent être constituées de pastilles ou de plages conductrices reliées à des segments conducteurs d'un circuit gravé chimiquement ou déposé par sérigraphie sur le substrat. Un tel circuit peut constituer par exemple l'antenne d'une carte sans contact servant à l'apport d'énergie à la carte et à l'échange de données numériques au moyen d'un terminal.

Il est important de noter que la méthode selon l'invention ne nécessite ni soudure, ni accrochage d'une manière quelconque des contacts du composant sur les conducteurs du circuit. Il suffit donc que les surfaces de contact du composant et du substrat soient pressées l'une contre l'autre en présentant des surfaces sensiblement planes. Le composant est retenu sur le substrat par la matière isolante qui le recouvre en s'étendant sur la périphérie du composant.

Le logement dans le substrat sert à maintenir temporairement le composant entre la phase de sa pose et du dépôt de la couche isolante. Ce logement peut être réalisé de plusieurs manières telles qu'une cavité dans le substrat obtenue par fraisage ou une fenêtre découpée par étampage, ou simplement par déformation du substrat par l'échauffement du composant lors de sa pose sur le substrat.

L'avantage du montage du composant selon cette méthode réside en ce que le contact entre le composant et les conducteurs du circuit est maintenu lorsque le transpondeur est fléchi ou tordu. En effet, les forces internes apparaissant au niveau de la connexion auront tendance à faire glisser les contacts les uns sur les autres sans occasionner de rupture comme dans le cas d'une connexion soudée ou ancrée. Des contraintes répétées exercées sur le transpondeur entraînent un effet "autonettoyant" des conducteurs par frottement de leur surfaces en contact. Par conséquent les performances de la connexion comme sa fiabilité et sa conductivité électrique se trouvent grandement améliorées.

L'invention sera mieux comprise grâce à la description détaillée qui va suivre et qui se réfère aux dessins annexés qui sont donnés à titre d'exemple nullement limitatif, dans lesquels:
- la figure 1 représente un composant sous forme d'un module électronique muni de plages de contact.
- la figure 2 représente une vue de dessus d'un transpondeur de faible épaisseur comprenant un substrat et un composant pourvu de plages de contact protégé par une couche isolante
- la figure 3 illustre une coupe agrandie du transpondeur de la figure 2 selon l'axe A-A
- la figure 4 illustre une coupe d'un assemblage d'un transpondeur comprenant deux substrats et un composant pourvu de plages de contact
- la figure 5 illustre une coupe d'un assemblage d'un transpondeur comprenant deux substrats et un composant constitué par une puce insérée dans l'un des substrats.

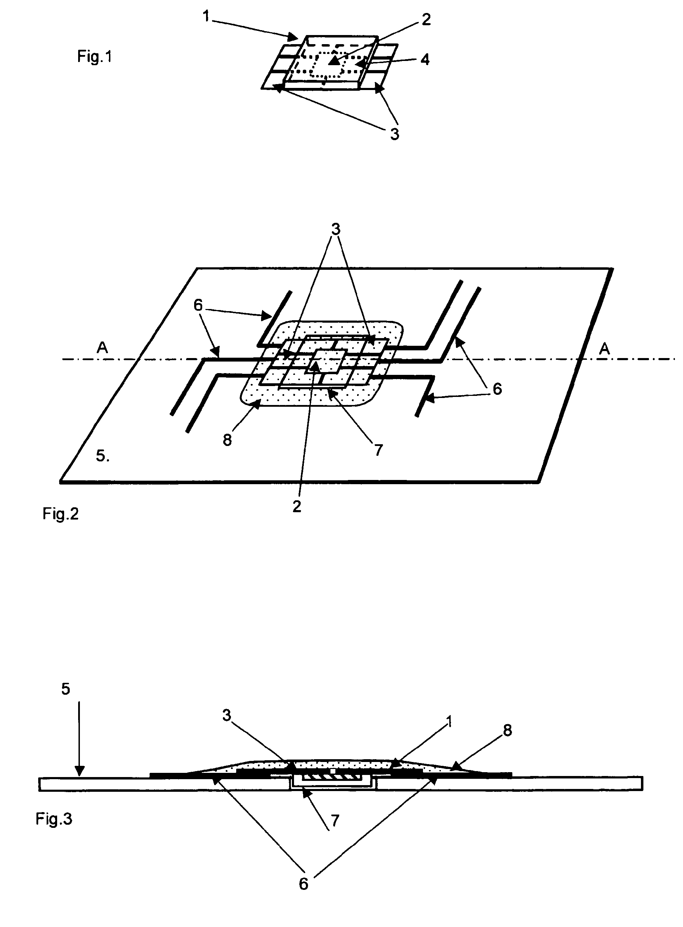

Le composant (1) de la figure 1 formant un module électronique comporte une puce (2) protégée par un surmoulage (4) en matière isolante telle que de la résine époxy. Les contacts de la puce sont connectés à des plages de contact (3) formées dans une feuille conductrice en cuivre étamé par exemple constituant le "leadframe".

La figure 2 et la coupe selon l'axe A-A illustrée par la figure 3 montrent un exemple de transpondeur comportant un substrat (5) de faible épaisseur pouvant être déformé sur lequel est placé le composant (1) de la figure 1. La surface supérieure de ce substrat comporte des pistes ou des plages conductrices (6) gravées, collées ou imprimées par sérigraphie par exemple. La partie surmoulée (4) du composant (1) est insérée dans un logement (7) constitué par une cavité usinée ou une fenêtre découpée dans le substrat de manière à minimiser l'épaisseur finale du transpondeur. Les pistes conductrices (6) du substrat sont en contact avec les plages conductrices (3) du composant uniquement par pression sans utilisation de soudure ou de colle conductrice. Les surfaces ainsi en contact sensiblement planes ne comportent aucun relief particulier pouvant servir de point d'ancrage. Le maintien du composant sur le substrat et de la pression sur ses contacts sont assurés par une couche isolante (8) répartie à la fois sur la surface apparente du composant et sur une zone du substrat voisine du composant. Selon une variante, cette couche isolante peut être répartie sur toute la surface supérieure du substrat.

Un transpondeur ainsi réalisé peut être déformé sans que les connexions du composant sur les conducteurs du substrat soient interrompues. Les plages de contact du "leadframe" auront tendance à frotter sur les pistes du substrat sous l'action des forces internes engendrées par la déformation du transpondeur.

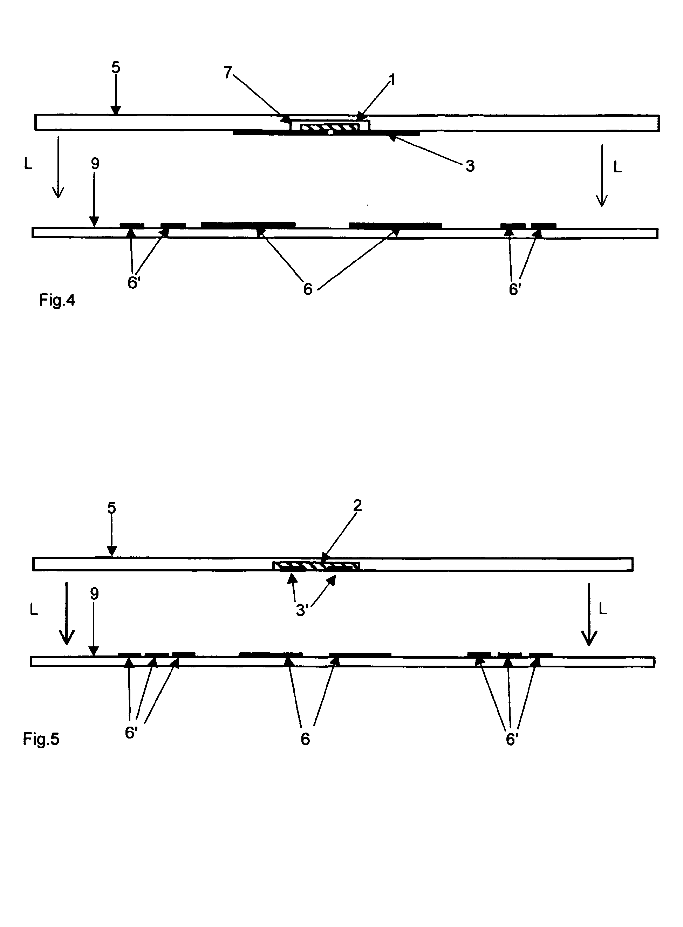

La figure 4 montre une variante de l'assemblage du transpondeur selon la méthode de l'invention où la partie surmoulée (4) du composant (1) est insérée dans une cavité ou chassée dans une fenêtre d'un premier substrat (5) isolant. Les plages conductrices (3) du composant sont ainsi disposées sur la surface inférieure du substrat (5). Un second substrat (9) comportant, sur sa surface supérieure, une pluralité de pistes conductrices comme par exemple une antenne (6') et des pistes de contact (6) situées en regard de celles du composant est appliqué sur le premier substrat (5). L'assemblage des deux substrats (5, 9) est effectué par collage ou laminage à chaud ou à froid suivant les flèches L. Le contact électrique du composant avec les pistes (6) du second substrat est réalisé par la pression du laminage ou du collage. L'épaisseur finale du transpondeur se limite à celle des deux substrats (5, 9) superposés.

Selon une autre variante, le composant (1) ne comporte pas de surmoulage, la puce (2) est alors protégée directement par le premier substrat (5). La puce est soit insérée dans une cavité (7) pré-usinée dans le substrat, soit enfoncée à chaud dans la matière du substrat de façon à ce que les plages de contact (3) du composant (1) s'appliquent contre la surface interne du substrat (5).

L'insertion directe du composant dans la matière du substrat sans cavité pré-usinée s'effectue par échauffement de la puce lors de sa pose entraînant un ramollissement local et une déformation du substrat. La puce est ensuite enfoncée dans le substrat au moyen d'un outillage approprié à la profondeur voulue. Le logement ainsi constitué est adapté au contour de la puce et maintient la position de la puce ou de l'ensemble du composant pendant le laminage du second substrat.

Le second substrat (9) est assemblé de la même manière que dans la variante précédente. L'épaisseur du premier substrat (5) peut ainsi être réduite à une valeur proche de celle de la puce.

La figure 5 représente une variante de l'assemblage d'un transpondeur où le composant est constitué uniquement par une puce (2) dépourvue de "leadframe". Dans ce cas, comme dans le précédent, la puce (2) est soit logée dans une cavité pré-usinée soit pressée dans la matière du premier substrat (5) de façon à faire apparaître ses plages de contacts (3') à fleur de la surface du substrat (5). Le second substrat (9) est muni de pistes conductrices (6) en regard de celles de la puce destinée à sa connexion par la pression du collage ou du laminage de l'ensemble des deux substrats (5, 9). Les plages de contact (3') de la puce (2) sont bien entendu planes ce qui permet leur frottement sur les pistes conductrices correspondantes du second substrat en cas de déformation du transpondeur.

La couche isolante déposée sur le composant et sur tout ou partie de la surface du substrat ainsi que le second substrat laminé sur le premier substrat peuvent comporter un décor ou un marquage sur la surface extérieure caractérisant le transpondeur final. En outre le premier substrat peut également comporter un décor sur la face opposée à celle supportant les pistes conductrices.

La méthode selon l'invention s'applique aussi à l'assemblage de cartes dites "dual" c'est-à-dire comprenant d'une part un ensemble de contacts plans affleurant une des faces extérieures de la carte et d'autre part une antenne interne sous forme d'un ensemble de pistes conductrices. Cet ensemble de contacts est situé sur une des faces d'un module et chaque contact est relié à une plage conductrice sur la face opposée du module. Ce dernier est inséré dans un logement muni d'une fenêtre découpée dans un premier substrat dont l'épaisseur est sensiblement égale à celle du module. L'ensemble de contacts affleure la surface du substrat constituant la face extérieure de la carte et les plages conductrices de la face opposée s'appuient sur des pistes conductrices d'un second substrat assemblé sur le premier substrat.

Une puce ou un module électronique supplémentaire tel que décrit précédemment, complétant cet assemblage, peut être monté dans l'un ou l'autre des substrats. Les plages conductrices de ce module se connectent par pression sur des pistes conductrices correspondantes de la surface d'un des substrats.

Il est également envisageable d'assembler puis de laminer plus de deux substrats superposés comprenant des pistes conductrices et des modules électroniques dont les plages conductrices se connectent par la pression du laminage sur des pistes conductrices correspondantes disposées sur les faces de l'un ou l'autre des substrats.

## Revendications

1. Procédé d'assemblage d'au moins un composant électronique (1) comportant des plages conductrices (3) sensiblement planes connectées à des pistes conductrices disposées sur la surface d'un support isolant généralement plan appelé substrat (5) comprenant les étapes suivantes:
- poser le substrat (5) sur une surface de travail, la face comportant les pistes conductrices (6, 6') étant dirigée vers le haut,
- placer le composant électronique (1) dans un logement (7) du substrat (5) situé dans une zone comportant les pistes conductrices (6, 6'), les plages conductrices (3) du composant (1) entrant en contact avec des pistes correspondantes du substrat (5),
- appliquer une couche de matière isolante (8) s'étendant à la fois sur le composant (1) et au moins sur une zone du substrat (5) entourant ledit composant (1),
ledit procédé est **caractérisé en ce que** le contact entre les plages conductrices (3) du composant électronique (1) et les pistes conductrices (6, 6') du substrat (5) réalise une connexion électrique assurée par la pression d'application de la couche isolante (8) sur le composant électronique (1).

2. Procédé selon la revendication 1 **caractérisé en ce que** le composant électronique (1) est formé d'une puce (2) munie de contacts sur une de ses faces, lesdits contacts étant rapportés sur une feuille conductrice constituant des plages de contact (3) prolongeant les contacts de la puce (2), la face opposée de la puce (2) est surmoulée par une matière isolante (4).

3. Procédé selon la revendication 1 **caractérisé en ce que** la couche de matière isolante est constituée par un premier substrat (5) comportant un logement (7) dans lequel est inséré le composant (1) par sa face surmoulée, les plages de contact (3) dudit composant se connectant avec des plages conductrices (6) correspondantes d'un second substrat (9) posé sur la surface de travail.

4. Procédé selon la revendication 1 **caractérisé en ce que** le composant électronique (1) est formé d'une puce (2) munie de contacts sur une de ses faces, lesdits contacts étant rapportés sur une feuille conductrice constituant des plages de contact (3) prolongeant les contacts de la puce (2).

5. Procédé selon les revendications 1 et 4 **caractérisé en ce que** la couche de matière isolante est constituée par un premier substrat (5) comportant un logement (7) dans lequel est insérée la puce (2) du composant (1), les plages de contact (3) dudit composant (1) s'appliquant contre la surface du substrat (5) se connectent avec des plages conductrices (6) correspondantes d'un second substrat (9) posé sur la surface de travail.

6. Procédé selon les revendications 1 et 4 **caractérisé en ce que** le logement du composant (7) est obtenu par échauffement de la puce (2) du composant (1) puis enfoncement de ladite puce (2) dans la matière du substrat (5) au moyen d'un outillage adéquat, les plages de contact (3) dudit composant (1) s'appliquant contre la surface du substrat (5).

7. Procédé selon la revendication 1 **caractérisé en ce que** le composant électronique (1) est formé d'une puce (2) munie de contacts sensiblement plans sur une de ses faces.

8. Procédé selon la revendication 7 **caractérisé en ce que** la couche de matière isolante est constituée par un premier substrat (5) comportant un logement (7) dans lequel est insérée la puce (2), les contacts de ladite puce affleurant la surface du substrat (5) se connectent avec des plages conductrices (6) correspondantes d'un second substrat (9) posé sur la surface de travail.

9. Procédé selon la revendication 1 **caractérisé en ce que** le logement (7) du composant (1) est constitué d'une cavité usinée ou d'une fenêtre étampée.

10. Procédé selon la revendication 8 **caractérisé en ce que** le logement (7) de la puce (2) est obtenu par échauffement puis enfoncement de ladite puce (2) dans la matière du substrat (5) au moyen d'un outillage adéquat, les plages de contact de ladite puce (2) affleurant la surface du substrat (5).

11. Procédé selon la revendication 1 **caractérisé en ce que** le composant électronique (1) est formé d'un module comportant sur une de ses faces un ensemble de contacts plans et sur la face opposée des plages conductrices reliées à chaque contact de l'ensemble.

12. Procédé selon les revendications 1 et 11 **caractérisé en ce que** le module est inséré dans un logement (7) muni d'une fenêtre découpée dans un premier substrat (5) d'épaisseur sensiblement égale à celle du module, l'ensemble de contacts plans affleure la surface dudit substrat (5) et les plages conductrices de la face opposée s'appuient sur des pistes conductrices (6') d'un second substrat (9) assemblé sur le premier substrat (5).

13. Procédé selon la revendication 12, **caractérisé en ce qu'**au moins un module ou une puce (2) supplémentaire est monté dans l'un ou l'autre des substrats (5, 9), ledit module comportant des plages conductrices (3) connectées par pression sur des pistes conductrices (6') correspondantes de l'un ou l'autre des substrats (5, 9).

14. Procédé selon les revendications 3 et 13 **caractérisé en ce qu'**il comporte une étape supplémentaire de collage et de pressage de l'assemblage formé par la superposition des substrats (5, 9).

## Claims

1. Assembly process of at least one electronic component (1) including sensibly flat conductive areas (3) that are connected to conductive tracks (6') placed on the surface of a generally flat insulating support, called substrate (5), comprising the following steps: - placing the substrate (5) on a work surface, the face including conductive tracks (6') being oriented upwards,
- placing the electronic component (1) into a cavity (7) of the substrate (5) situated in a zone including the conductive tracks (6'), the conductive areas (3) of the electronic component (1) coming into contact with the corresponding tracks (6') of the substrate (5),
- applying a layer of insulating material (8) which extends at the same time on the electronic component (1) and at least on a substrate zone surrounding said component (1),
said process is **characterized in that** the contact between the conductive areas (3) of the electronic component (1) and the conductive tracks (6, 6') of the substrate (5) realizes an electric connection ensured by the pressure of application of the insulating material (8) layer on the electronic component (1).

2. Process according to claim 1 **characterized in that** the electronic component (1) is made up of a chip (2) provided with contacts on one of its faces, said contacts being set off on a conductive film constituting the contact areas that extend the contacts of the chip (2), the opposite face of the chip being coated by an insulating material (4).

3. Process according to claim 1 **characterized in that** the layer of insulating material is made up of a first substrate (5) including a cavity (7) into which the component (1) is inserted by its coated face, the contact areas (3) of said component (1) connecting with corresponding conductive areas (6) of a second substrate (9) placed on the work surface.

4. Process according to claim 1 **characterized in that** the electronic component (1) is made up of a chip (2) provided with contacts on one of its faces, said contacts being set off on a conductive film constituting the contact areas (3) that extend the contacts of the chip (2).

5. Process according to claims 1 and 4 **characterized in that** the layer of insulating material is made up of a first substrate (5) including a cavity (7) in which the chip (2) of the component (1) is inserted, the contact areas (3) of said component (1) being applied against the surface of the substrate (5) connecting with corresponding conductive areas (6) of a second substrate (9) placed on the work surface.

6. Process according to claims 1 and 4 **characterized in that** the cavity (7) of the component (1) is obtained by heating the chip (2) of the component (1) then pushing said chip (2) into the substrate (5) material by means of adequate tooling, the contact areas (3) of said component (1) being applied against the surface of the substrate (5).

7. Process according to claim 1 **characterized in that** the electronic component (1) is made up of a chip (2) provided with sensibly flat contacts on one of its faces.

8. Process according to claim 7 **characterized in that** the layer of insulating material is made up of a first substrate (5) including a cavity (7) into which the chip (2) is inserted, the contacts of said chip showing on the surface level of the substrate are connected with corresponding conductive areas (6) of a second substrate (9) placed on the work surface.

9. Process according to claim 1 **characterized in that** the cavity (7) of the component (1) is made up by milling or by stamping a window.

10. Process according to claim 8 **characterized in that** the cavity (7) of the chip (2) is obtained by heating then pressing said chip (2) into the material of the substrate (5) by means of adequate tooling, the contact areas of said chip (2) showing on the surface level of the substrate.

11. Process according to claim 1 **characterized in that** the electronic component (1) is made up of a module including a set of flat contacts on one of its faces and on the opposite face conductive areas linked to each contact of the set.

12. Process according to claim 11 **characterized in that** the module is inserted into a cavity (7) provided with a window cut into a first substrate (5) with a thickness approximately equal to that of the module, the set of flat contacts shows on the surface level of said substrate (5) and the conductive areas of the opposite face lean against the conductive tracks (6') of a second substrate (9) assembled on the first substrate (5).

13. Process according to claim 12, **characterized in that** at least one module or a supplementary chip (2) is mounted in one of the substrates (5, 9), said module including conductive areas (3) connected by pressure on the corresponding conductive tracks (6') of either of the substrates (5, 9).

14. Process according to claims 3 and 13 **characterized in that** it includes a supplementary step of gluing and pressing the assembly formed by the superposition of the substrates (5, 9).

## Patentansprüche

1. Verfahren der Montage zumindest eines elektronischen Bauteils (1) mit im Wesentlichen flachen leitenden Bereichen (3), die mit Leiterbahnen verbunden werden, die auf der Oberfläche eines isolierenden, allgemein flachen und als Substrat (5) bezeichneten Trägers angeordnet sind, die folgenden Schritte umfassend:
- Auflegen des Substrats (5) auf eine Arbeitsfläche mit der die Leiterbahnen (6, 6') aufweisenden Seite nach oben,
- Einsetzen des elektronischen Bauteils (1) in einen Platz (7) im Substrat (5), der sich in einem Bereich mit den Leiterbahnen (6, 6') befindet, wobei die leitenden Bereiche (3) des Bauteils (1) mit den entsprechenden Leiterbahnen des Substrats (5) in Berührung treten,
- Aufbringen einer Schicht aus isolierendem Material (8), die sich zugleich über das Bauteil (1) und über zumindest einen dieses Bauteil (1) umgebenden Bereich des Substrats (5) erstreckt,
wobei das Verfahren **dadurch gekennzeichnet ist, dass** der Kontakt zwischen den leitenden Bereichen (3) des elektronischen Bauteils (1) und den Leiterbahnen (6, 6') des Substrats (5) eine elektrische Verbindung herstellt, die durch den Druck des Aufbringens der isolierenden Schicht (8) auf das elektronische Bauteil (1) gewährleistet wird.

2. Verfahren nach Anspruch 1, **dadurch gekennzeichnet, dass** das elektronische Bauteil (1) aus einem Chip (2) besteht, der auf einer seiner Seiten mit Kontakten versehen ist, die auf eine Leitfolie übergehen, die Kontaktstreifen (3) darstellt, die die Kontakte des Chips (2) verlängern, wobei die entgegengesetzte Seite des Chips (2) mit einem isolierenden Material (4) vergossen wird.

3. Verfahren nach Anspruch 1, **dadurch gekennzeichnet, dass** die Schicht aus isolierendem Material aus einem ersten Substrat (5) besteht, das einen Aufnahmeplatz (7) aufweist, in den das Bauteil (1) mit seiner vergossenen Seite eingesetzt wird, wobei sich die Kontaktstreifen (3) des Bauteils mit entsprechenden leitenden Bereichen (6) eines zweiten Substrats (9) verbinden, das auf die Arbeitsfläche gelegt wurde.

4. Verfahren nach Anspruch 1, **dadurch gekennzeichnet, dass** das elektronische Bauteil (1) aus einem Chip (2) besteht, der auf einer seiner Seiten mit Kontakten versehen ist, die auf eine Leitfolie übertragen werden, die Kontaktstreifen (3) darstellt, die die Kontakte des Chips (2) verlängern.

5. Verfahren nach Ansprüchen 1 und 4, **dadurch gekennzeichnet, dass** die Schicht aus isolierendem Material aus einem ersten Substrat (5) besteht, das einen Aufnahmeplatz (7) aufweist, in den der Chip (2) des Bauteils (1) eingesetzt wird, wobei sich die Kontaktstreifen (3) des Bauteils (1), die an die Oberfläche des Substrats (5) angedrückt werden, mit den entsprechenden leitenden Bereichen (6) eines zweiten Substrats (9) verbinden, das auf die Arbeitsfläche gelegt wurde.

6. Verfahren nach Ansprüchen 1 und 4, **dadurch gekennzeichnet, dass** der Aufnahmeplatz des Bauteils (7) durch Erhitzen des Chips (2) des Bauteils (1) und nachfolgendes Eindrücken des Chips (2) mittels geeigneter Werkzeuge in das Material des Substrats (5) gewonnen wird, wobei sich die Kontaktstreifen (3) des Bauteils (1) an die Oberfläche des Substrats (5) andrücken.

7. Verfahren nach Anspruch 1, **dadurch gekennzeichnet, dass** das elektronische Bauteil (1) aus einem Chip (2) besteht, der auf einer seiner Seiten mit im Wesentlichen ebenen Kontakten versehen ist.

8. Verfahren nach Anspruch 7, **dadurch gekennzeichnet, dass** die Schicht aus isolierendem Material aus einem ersten Substrat (5) besteht, das einen Aufnahmeplatz (7) aufweist, in den der Chip (2) eingesetzt wird, wobei sich die Kontakte des Chips, die mit der Oberfläche des Substrats (5) bündig abschliessen, mit den entsprechenden leitenden Bereichen (6) eines zweiten Substrats (9) verbinden, das auf die Arbeitsfläche gelegt wurde.

9. Verfahren nach Anspruch 1, **dadurch gekennzeichnet, dass** der Aufnahmeplatz (7) des Bauteils (1) aus einem herausgearbeiteten Hohlraum oder einem ausgestanzten Fenster besteht.

10. Verfahren nach Anspruch 8, **dadurch gekennzeichnet, dass** der Aufnahmeplatz (7) des Chips (2) durch Erhitzen und nachfolgendes Eindrücken des Chips (2) mittels geeigneter Werkzeuge in das Material des Substrats (5) gewonnen wird, wobei die Kontaktstreifen des Chips (2) bündig mit der Oberfläche des Substrats (5) abschliessen.

11. Verfahren nach Anspruch 1, **dadurch gekennzeichnet, dass** das elektronische Bauteil (1) aus einem Modul besteht, der auf einer seiner Seiten eine Gruppe von ebenen Kontakten und auf der entgegengesetzten Seite leitende Bereiche aufweist, die mit jedem Kontakt der Gruppe verbunden sind.

12. Verfahren nach Ansprüchen 1 und 11, **dadurch gekennzeichnet, dass** der Modul in einen Aufnahmeplatz (7) eingesetzt wird, der mit einem Fenster versehen ist, das aus einem ersten Substrat (5) von im Wesentlichen der gleichen Dicke wie der Modul herausgeschnitten worden ist, wobei die Gruppe von ebenen Kontakten bündig mit der Oberfläche des Substrats (5) abschliesst und die leitenden Bereiche der entgegengesetzten Seite auf Leiterbahnen (6') eines zweiten Substrats (9) aufliegen, das auf das ersten Substrat (5) montiert ist.

13. Verfahren nach Anspruch 12, **dadurch gekennzeichnet, dass** zumindest ein zusätzlicher Modul oder Chip (2) auf das eine oder das andere der Substrate (5, 9) montiert wird, wobei der Modul leitende Bereiche (3) aufweist, die durch Druck mit entsprechenden Leiterbahnen (6') des einen oder anderen der Substrate (5, 9) verbunden werden.

14. Verfahren nach Ansprüchen 3 und 13, **dadurch gekennzeichnet, dass** es einen zusätzlichen Schritt des Verklebens und Pressens der durch das Übereinanderlegen der Substrate (5, 9) gebildeten Zusammenstellung aufweist.
